(19) Europäisches Patentamt

European Patent Office

Office européen des brevets

(11) **EP 0 399 242 B1**

(12) **EUROPÄISCHE PATENTSCHRIFT**

(45) Veröffentlichungstag und Bekanntmachung des Hinweises auf die Patenterteilung:
**20.03.1996 Patentblatt 1996/12**

(51) Int Cl.6: **H03K 17/945**, H03K 17/95, H03K 17/14

(21) Anmeldenummer: **90108020.0**

(22) Anmeldetag: **27.04.1990**

(54) **Temperaturstabiler induktiver Näherungsschalter**

Temperature stabilized inductive proximity switch

Commutateur de proximité inductif stable en température

(84) Benannte Vertragsstaaten:
**AT BE CH DE DK ES FR GB GR IT LI LU NL SE**

(30) Priorität: **19.05.1989 DE 3916386**
**07.08.1989 DE 3926083**

(43) Veröffentlichungstag der Anmeldung:
**28.11.1990 Patentblatt 1990/48**

(73) Patentinhaber: **Festo KG**
**D-73734 Esslingen (DE)**

(72) Erfinder:
• **Kriz, Dieter**
**D-5880 Lüdenscheid (DE)**

• **Heer, Peter**
**D-5242 Kirchen 1 (DE)**

(74) Vertreter: **Reimold, Otto, Dipl.-Phys.Dr. et al**
**Patentanwälte**
**Dipl.-Ing. R. Magenbauer**
**Dipl.-Phys. Dr. O. Reimold**
**Dipl.-Phys.Dr. H. Vetter**
**Dipl.-Ing. Martin Abel**
**Hölderlinweg 58**
**D-73728 Esslingen (DE)**

(56) Entgegenhaltungen:
WO-A-90/08429          CH-A- 668 872
DE-A- 3 248 169          DE-A- 3 320 509
DE-A- 3 322 701          DE-A- 3 527 650

**Beschreibung**

Die Erfindung bezieht sich auf einen induktiven Näherungsschalter mit einem transistorisierten Schwingkreisoszillator und einer im Emitterkollektorkreis des Schwingkreistransistors liegenden Stromquelle, die in Abhängigkeit von einer thermisch mit dem Schwingkreisoszillator gekoppelten Temperaturfühleinrichtung mittels einer Steuereinrichtung derart gesteuert wird, daß der Schaltabstand des Näherungsschalters temperaturstabil ist.

Für verschiedene Schaltabstände benötigt ein induktiver Näherungsschalter verschiedene Schwingkreisspulen. Damit der Schwingkreisoszillator schwingt, ist es erforderlich, den Schwingkreis mit einem ausreichend großen Grundstrom zu versorgen. Es ist bekannt, daß das Schwingungsverhalten transistorisierter Schwingkreisoszillatoren von der Umgebungstemperatur abhängt. Da bei induktiven Näherungsschaltern eine hohe Empfindlichkeit verlangt wird, weil anders der Näherungsschalter auf geringfügige Abstandsänderungen des zu erfassenden Zieles nicht genau genug reagiert, wirkt sich die Temperaturabhängigkeit negativ auf die Genauigkeit des Näherungsschalters aus.

Um einen Schwingkreisoszillator temperaturstabil zu machen, gibt es verschiedene Möglichkeiten.

So hat man versucht, die Temperaturabhängigkeit mittels eines im Rückkopplungszweig des Schwingkreistransistors angeordneten temperaturabhängigen Widerstandes (NTC-Widerstand) zu kompensieren. Eine solche Temperaturkompensation hat mehrere Nachteile:

a) Die Kompensation mittels des temperaturabhängigen Widerstandes ist nicht optimal, weil die temperaturabhängige Widerstandskennlinie der Schwingkreisspule linear ist, die Widerstandskennlinie des temperaturabhängigen Widerstandes aber einer e-Funktion folgt.

b) Die Anfangstoleranzen des temperaturabhängigen Widerstandes sind mit +/- 20 % recht groß und seine Langzeitstabilität ist relativ schlecht.

c) Der temperaturabhängige Widerstand befindet sich im HF-durchflossenen Rückkopplungszweig und muß deshalb in unmittelbarer Nähe des Schwingkreisoszillators angeordnet sein. Eine thermische Kopplung mit der Spule, die die Voraussetzung für eine gute Temperaturkompensation ist, würde deshalb zu für HF zu langen Verbindungsleitungen des Widerstandes führen.

d) Der in der Regel übliche Abgleichwiderstand zur Einstellung des Schaltabstandes, der in Reihe mit dem temperaturabhängigen Widerstand liegt, beeinflußt die Kompensationswirkung des temperaturabhängigen Widerstandes.

e) Da der Abgleichwiderstand HF-durchflossen ist, muß er ebenfalls in der Nähe des Schwingkreisoszillators angeordnet sein. Deshalb kann er nicht mit langen Verbindungsleitungen an das hintere Ende des als Hybridschaltung ausgebildeten Schwingkreisoszillators angeordnet werden, was für einen einfachen Laserabgleich günstig wäre.

Um eine bessere Temperaturkompensation zu bekommen, ist bei einer anderen Lösung (DE 35 27 650 Al) im Emitterkollektorkreis des Schwingkreistransistors eine Stromquelle angeordnet, mit der in Abhängigkeit von der Temperatur des Oszillators ein Kompensationsstrom in den Emitterkollektorkreis eingespeist werden kann, so daß die Kreisverstärkung über die Temperatur konstant gehalten wird. Dabei wird die Temperatur mittels eines als Diode ausgebildeten Temperaturfühlers erfaßt. Eine solche "summarische" Kompensation der Temperaturabhängigkeit verschiedener Bauteile des Oszillators ist nicht optimal, weil die verschiedenen Bauteile einen verschiedenen Temperaturgang haben.

In der älteren, jedoch nicht vorveröffentlichten WO 90/08429, die Stand der Technik in Sinne von Art. 54(1) (3)(4) EPÜ für alle benannten Vertragsstaaten außer GR ist, ist ein induktiver Näherungsschalter mit einem transistorisierten Schwingkreisoszillator und einer im Emitterkreis des Schwingkreisoszillators liegenden Stromquelle beschrieben, die in Abhängigkeit von einer thermisch mit der Schwingkreisspule gekoppelten Temperaturfühleinrichtung mittels einer Steuereinrichtung derart gesteuert wird, daß der Schaltabstand des Näherungsschalters temperaturstabil ist. Über die Steuereinrichtung wird bei mit ansteigender Temperatur der Schwingkreisspule größer werdendem Widerstand die Stromquelle aufgesteuert und umgekehrt. Insoweit stimmt dieser Näherungsschalter mit dem erfindungsgemäßen Näherungsschalter überein, unterscheidet sich jedoch bezüglich der übrigen Merkmale.

Der Erfindung liegt die Aufgabe zugrunde, einen Näherungsschalter der eingangs genannten Art zu schaffen, der temperaturabhängig auf die zu erfassenden Ziele reagiert.

Diese Aufgabe wird erfindungsgemäß bei dem Näherungsschalter der eingangs genannten Art dadurch gelöst, daß die Temperaturfühleinrichtung einen ersten Temperaturfühler in Form eines thermisch mit der Schwingkreisspule gekoppelten Elementes, das über die Steuereinrichtung bei mit ansteigender Temperatur der Schwingkreisspule größer werdendem Widerstand die Stromquelle aufsteuert und umgekehrt, und einen zweiten thermisch mit dem Schwingkreistransistor gekoppelten Temperaturfühler aufweist, der bei in Basisschaltung betriebenem Schwingkreistransistor über die Steuereinrichtung den Kompensationsstrom der Stromquelle ausschließlich in Abhängigkeit von der Temperatur des Schwingkreistransistors im Sinne einer Konstanthaltung der Steilheit des Schwingkreistransistors einstellt und bei in Emitterschaltung betriebenem Schwingkreistransistor über die Steuereinrichtung den Kompensationsstrom der Stromquelle zusätzlich zu der Abhängigkeit von der Temperatur des Schwingkreistransistors in Abhängigkeit von dem eingestellten Grundstrom des Schwingkreistransistors im Sinne einer Konstanthaltung des Stromverstärkungsfaktors des Schwingkreistransistors einstellt.

Bei der Erfindung werden die Temperaturen der für eine Temperaturabhängigkeit verantwortlichen Bauteile des Näherungsschalters individuell erfaßt und bauteilabhängige Gegenmaßnahmen über die Einspeisung eines Kompensationsstroms getroffen, so daß im Ergebnis der Näherungsschalter temperaturunabhängig ist. Ein weiterer Vorteil bei der Erfindung ist, daß kein Element für die Temperaturkompensation in einem HF-durchflossenen Zweig liegt. Deshalb läßt sich der Temperaturfühler für die Schwingkreisspule ohne Nachteile für die Kompensation auch mit langen Verbindungsleitungen bis zur Schwingkreisspule hin verlegen. Die thermische Kopplung zwischen Temperaturfühler und Schwingkreisspule kann deshalb sehr eng sein, insbesondere kann der Temperaturfühler auf der Schwingkreisspule angeordnet sein. Dies läßt sich insbesondere mit einem Transistor verwirklichen, der dann die gleiche Temperatur wie die Schwingkreisspule hat. Da der Transistor eine lineare Kennlinie in engen Toleranzen und eine gute Langzeitstabilität hinsichtlich seiner Daten hat, ist eine optimale Temperaturkompensation der ebenfalls eine lineare Kennlinie aufweisenden Schwingkreisspule gewährleistet. Eventuell unterschiedliche Steilheiten der linearen Kennlinien der Schwingkreisspule und des an ihr angebrachten Transistors lassen sich beispielsweise durch einen der Stromquelle vorgeschalteten Multiplizierer anpassen.

Von den beiden alternativen Möglichkeiten des Betriebes in Basis- oder Emitterschaltung wird die erste bevorzugt, weil auf diese Art und Weise die Kompensation am einfachsten ist, denn hier beruht die Steuerung des eingespeisten Kompensationsstroms auf dem linearen Zusammenhang der Steilheit und der Temperatur des Schwingkreistransistors. Im zweiten Fall ist für die Temperaturkompensation der Grundstrom zu berücksichtigen, weil man die Erfahrung gemacht hat, daß bei Schaltabstandsänderungen des Näherungsschalters verschiedene Grundströme bei verschiedenen Temperaturänderungen deshalb unterschiedlich sind, weil der Stromverstärkungsfaktor des Schwingkreistransistors nicht nur eine nicht lineare Abhängigkeit von der Temperatur, sondern auch vom Kollektorstrom hat.

Auch wenn die thermische Kopplung zwischen einem auf der Schwingkreisspule angeordneten Temperaturfühler schon sehr eng ist, kann nach einer weiteren Ausgestaltung der Erfindung die Erfassung der Temperatur weiter verbessert werden. Nach dieser Ausgestaltung wird der Temperaturfühler von dem als ohmschen Widerstand wirkenden ferritischen Kern der Schwingkreisspule gebildet, für dessen einer e-Funktion folgenden Widerstandskennlinie die Steuereinrichtung eine Linearisierung umfaßt. Dabei kann die Steuereinrichtung über zwei Meßleitungen unmittelbar an beabstandeten Anschlußpunkten des Ferritkerns elektrisch angeschlossen sein, wobei die Anschlußpunkte diametral gegenüberliegen sollten.

Diese Ausgestaltung zeichnet sich gegenüber anderen thermischen Kopplungen dadurch aus, daß sich durch Benutzung des ohnehin vorhandenen ferritischen Kerns der Schwingkreisspule eine unmittelbare thermische Kopplung zwischen dem Temperaturfühler und der temperaturabhängigen Schwingkreisspule ergibt, was Voraussetzung für eine präzisere Temperaturkompensation ist. Im Vergleich zu NTC-Widerständen als Temperaturfühler hat der ferritische Kern nicht die Nachteile großer Anfangstoleranzen und geringer Langzeitstabilität.

Auch der Temperaturfühler, der thermisch mit dem Schwingkreistransistor gekoppelt ist, sollte vorzugsweise ein Transistor sein. In diesem Fall können im Sinne einer optimalen thermischen Kopplung beide Transistoren auf demselben Halbleiterkristall ausgebildet sein.

Im folgenden wird die Erfindung anhand von verschiedene Ausführungsbeispiele von induktiven Näherungsschaltern darstellenden Schaltbildern näher erläutert. Im einzelnen zeigen:

Figur 1     einen Näherungsschalter, bei dem die Steilheit des Schwingkreistransistors konstant gehalten wird,

Figur 2     einen Näherungsschalter, bei dem der Stromverstärkungsfaktor des Schwingkreistransistors konstant gehalten wird,

Figur 3     eine Schwingkreisspule des Schwingkreisoszillators des Näherungsschalters gemäß Figur 1 oder 2 in Seitenansicht,

Figur 4     die Schwingkreisspule gemäß Figur 3 in Aufsicht **und**

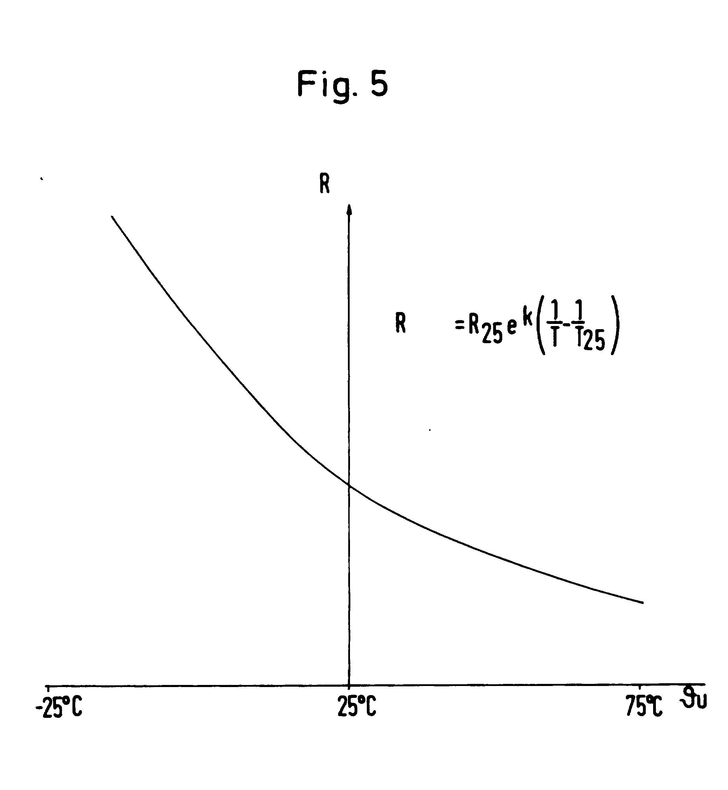

Figur 5     eine temperaturabhängige Widerstandskennlinie des Ferritkerns der Schwingkreisspule gemäß Figur 2 und 3.

Bei beiden Ausführungsbeispielen liegt an einer Gleichspannungsquelle $U_B$ eine Reihenschaltung aus einem Schwingkreis mit einer Schwingkreisspule 1 und Schwingkreiskondensatoren 2a,2b und einem Schwingkreistransistor T1. Der in Basisschaltung betriebene Schwingkreistransistor T1 ist mit dem Schwingkreis 1,2a,2b mitgekoppelt. Der Schwingkreis 1,2a,2b und der mitgekoppelte Schwingkreistransistor T1 bilden den Oszillator, und zwar einen sogenannten Colpittsoszillator.

Im Emitterkollektorkreis des Schwingkreistransistors T1 liegt eine Stromquelle I1, die auf einen für den Betrieb des Schwingkreises 1,2a,2b,T1 erforderlichen Grundstrom einstellbar ist. Von einer zweiten einstellbaren Stromquelle I2 wird inden Emitterkollektorkreis des Schwingkreistransistors T1 ein Kompensationsstrom eingespeist. Die Größe dieses Kompensationsstroms wird von einer Steuereinrichtung S1 bestimmt. Die Steuereinrichtung S1 umfaßt als Sensor für die Temperatur des Schwingkreistransistors T1 einen Transistor T2, der zum Zwecke der Temperaturkopplung auf demselben Halbleiterkristall wie der Schwingkreistransistor T1 angeordnet ist.

Die Steuereinrichtung S1 umfaßt ferner eine Schaltung, die die individuellen Daten der Transistoren T1,T2, insbesondere das Kennlinienfeld der Steilheit S des Schwingkreistransistors T1 berücksichtigt. Für die Steilheit gilt der bekannte Zusammenhang:

$$S = \frac{I_S}{U_T} \, e^{U_{BF}/U_T} = \frac{I_C}{U_T}$$

mit

$$U_T = \frac{K.T}{e_0} = \frac{1,38.10^{-23} J/K.T}{1,60.10^{-19} C}$$

Wird also die Temperatur durch den Transistor T2 festgestellt, dann läßt sich in Abhängigkeit von der Temperatur zur Konstanthaltung der Steilheit S der Strom der Stromquelle I2 und damit der Kollektorstrom IC derart steuern, daß die Steilheit S konstant bleibt.

Im Kollektoremitterkreis des Schwingkreistransistors T1 liegt eine dritte Stromquelle I3, die von einer Steuereinrichtung S2 angesteuert ist. Die Steuereinrichtung S2 umfaßt einen Temperaturfühler in Form eines Transistors T3, der zum Zwecke der Temperaturkopplung auf dem Kern der Schwingkreisspule aufgeklebt sein kann. In Abhängigkeit von der vom Temperaturfühler T3 erfaßten Temperatur der Schwingkreisspule 1 steuert die Steuereinrichtung S2 die Stromquelle I3 mit steigender Temperatur der Schwingkreisspule 1 auf und bei fallender Temperatur runter.

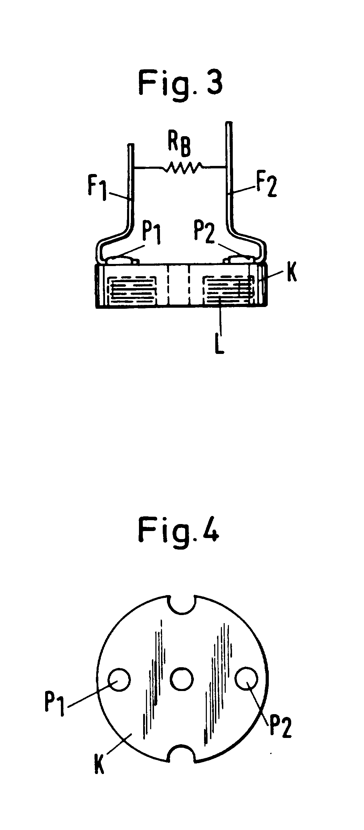

Anstelle des als Transistors T3 ausgebildeten Temperaturfühlers kann ein Temperaturfühler entsprechend dem Ausführungsbeispiel der Figuren 3 und 4 eingesetzt werden. Nach diesem Ausführungsbeispiel besteht die Schwingkreisspule 1 aus der Wicklung L und dem topfförmigen Kern K. Die Wicklung L ist in dem Topf eingegossen und auf diese Art und Weise thermisch eng mit dem Kern K gekoppelt. Der Kern K besteht aus ferritischem Material, das einen temperaturabhängigen, nicht linearen Widerstand hat. Das Temperaturverhalten des Widerstandes wird durch folgende Funktion bestimmt:

$$R_{Kern} = R_{25} e^{k\left(\frac{1}{T} - \frac{1}{T_{25}}\right)}$$

wobei die Werte $R_{25}$, K, $T_{25}$ folgende Bedeutung haben:

$R_{25}$: Widerstand des Ferritkerns bei 25°C

K : Ferritspezifische Konstante

$T_{25}$: 273,15 K + 25 (absolute Temperatur bei 25°C)

T : 273,15 K + $\vartheta u$(C°) (absolute Umgebungstemperatur)

Auf dem Kern K sind an diametral gegenüberliegenden Stellen Meßleitungen $F_1$, $F_2$ der Steuereinrichtung S2 angeschlossen. Parallel zu dem den ohmschen Widerstand bildenden Kern K liegt ein Überbrückungswiderstand RB. Die Steuereinrichtung S2 linearisiert das über die Meßleitungen $F_1$, $F_2$ erhaltene temperaturabhängige Signal, so daß die Steuereinrichtung mit einem linearen Ausgangssignal die Stromquelle $I_3$ ansteuert und damit auf temperaturbedingte lineare Änderungen der Bedämpfung der Schwingkreisspule 1 im Sinne einer Kompensation reagiert.

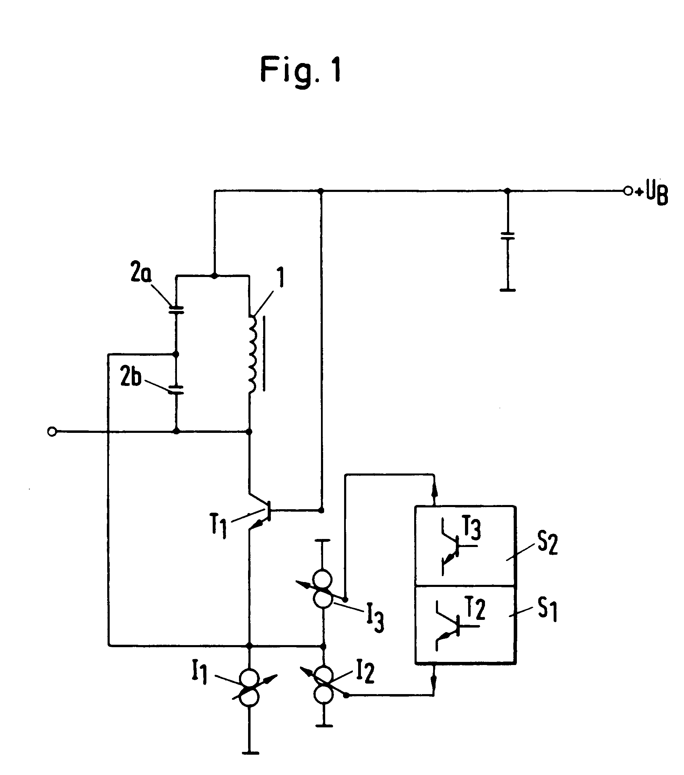

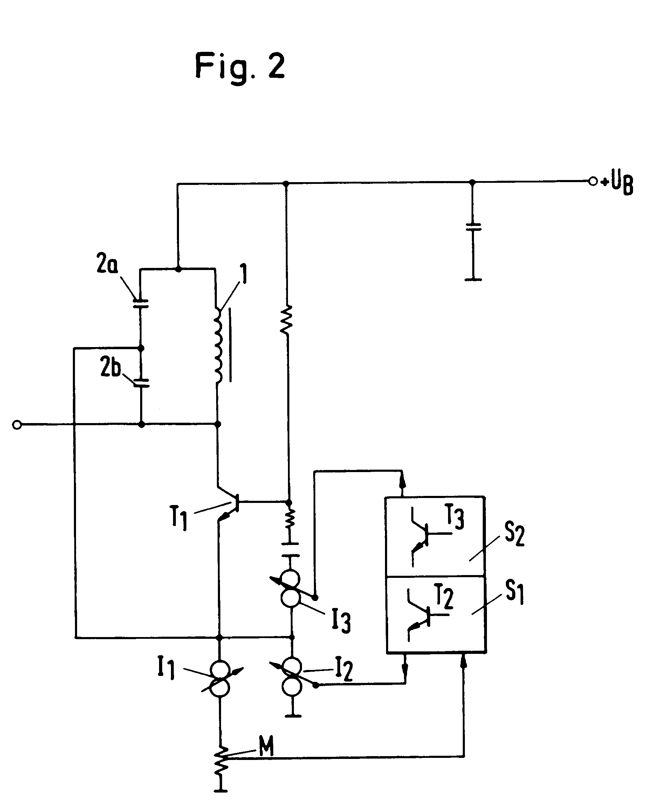

Das Ausführungsbeispiel der Fig. 2 unterscheidet sich von dem der Fig. 1 vor allem darin, daß im Emitterkollektorkreis des Schwingkreistransistors T1 ein Meßorgan M angeordnet ist, das einen Meßwert für den Strom im Emitterkollektorkreis an die Steuereinrichtung S1 liefert. In diesem Fall umfaßt die Steuereinrichtung S1 das Kennlinienfeld des Stromverstärkungsfaktors β des Schwingkreistransistors T1. In Abhängigkeit von den Betriebskennwerten, also vom Strom im Emitterkollektorkreis und der Temperatur der Transistoren T1 und T2 sorgt die Steuereinrichtung S1 dafür, daß bei jedem für die Schwingkreisspule 1 gewählten Grundstrom wegen des konstantgehaltenen Stromverstärkungsfaktors der Näherungsschalter einen temperaturstabilen Schaltabstand hat.

Beim Ausführungsbeispiel der Fig. 2 ist die Erfindung bei einem Oszillator in Emitterschaltung verwirklicht; günstiger ist allerdings, einen Oszillator in Basisschaltung gemäß Figur 1 zu betreiben, bei dem die Steuerung der Stromquelle I2 ausschließlich in Abhängigkeit von der Temperatur des Schwingkreistransistors I1 erfolgt, um dessen Steilheit konstantzuhalten.

Im Ergebnis wird bei dem erfindungsgemäßen Näherungsschalter ein temperaturunabhängiger Schaltabstand erhalten.

**Patentansprüche**

1. Induktiver Näherungsschalter mit einem transistorisierten Schwingkreisoszillator (1,2a,2b,T1) und einer im Emitterkreis des Schwingkreistransistors (T1) liegenden Stromquelle (I1,I2,I3), die in Abhängigkeit von einer thermisch mit dem Schwingkreisoszillator (1,2a,2b,T1) gekoppelten Temperaturfühleinrichtung (T2,T3,K) mittels einer Steuereinrichtung (S1,S2) derart gesteuert wird, daß der Schaltabstand des Näherungsschalters temperaturstabil ist

   **dadurch gekennzeichnet,** daß die Temperaturfühleinrichtung einen ersten Temperaturfühler in Form eines thermisch mit der Schwingkreisspule (1) gekoppelten Elementes (T3,K), das über die Steuereinrichtung (S1,S2) bei mit ansteigender Temperatur der Schwingkreisspule (1) größer werdendem Widerstand die Stromquelle (I3) aufsteuert und umgekehrt, und einen zweiten thermisch mit dem Schwingkreistransistor (T1) gekoppelten Temperaturfühler (T2) aufweist, der bei in Basisschaltung betriebenen Schwingkreistransistor (T1) über die Steuereinrichtung (S1) den Kompensationsstrom der Stromquelle (I1) ausschließlich in Abhängigkeit von der Temperatur des Schwingkreistransistors (T1) im Sinne einer Konstanthaltung der Steilheit des Schwingkreistransistors (T1) und bei in Emitterschaltung betriebenem Schwingkreistransistor über die Steuereinrichtung (S1) den Kompensationsstrom der Stromquelle (I2) zusätzlich zu der Abhängigkeit von der Temperatur des Schwingkreistransistors (T1) in Abhängigkeit von dem eingestellten Grundstrom des Schwingkreistransistors im Sinne einer Konstanthaltung des Stromverstärkungsfaktors des Schwingkreistransistors (T1) einstellt.

2. Näherungsschalter nach Anspruch 1,
**dadurch gekennzeichnet,** daß der mit der Schwingkreisspule (1) gekoppelte Temperaturfühler ein Transistor (T3) ist.

3. Näherungschalter nach Anspruch 2,
**dadurch gekennzeichnet,** daß der Transistor (T3) unmittelbar an der Schwingkreisspule (1) angebracht ist.

4. Näherungsschalter nach Anspruch 3,
**dadurch gekennzeichnet,** daß bei einer einen Kern aufweisenden Schwingkreisspule (1) der Transistor (T3) am Kern angebracht ist.

5. Näherungsschalter nach Anspruch 1,
**dadurch gekennzeichnet,** daß bei einer einen ferritischen Kern (K) aufweisenden Schwingkreisspule (1) der Temperaturfühler von dem als ohmschen Widerstand wirkenden ferritischen Kern (K) gebildet ist, für dessen einer e-Funktion folgenden Widerstandskennlinie die Steuereinrichtung (S2) eine Linearisierung aufweist.

6. Näherungsschalter nach Anspruch 5,
**dadurch gekennzeichnet,** daß die Steuereinrichtung (S2) über zwei Meßleitungen (F1,F2) unmittelbar an beabstandeten Anschlußpunkten (P1,P2) des Ferritkerns (K) elektrisch angeschlossen ist.

7. Näherungsschalter nach einem der Ansprüche 1 - 6,
**dadurch gekennzeichnet**, daß der mit dem Schwingkreistransistor (T1) thermisch gekoppelte Temperaturfühler (T2) ein Transistor ist.

8. Näherungsschalter nach Anspruch 7,
**dadurch gekennzeichnet**, daß die beiden thermisch miteinander gekoppelten Transistoren (T1, T2) auf demselben Halbleiterkristall ausgebildet sind.

**Claims**

1. Inductive proximity switch with a transistorized resonant circuit oscillator (1,2a,2b,TI) and a current source (I1,I2,I3) located in the emitter circuit of the resonant circuit transistor (T1) which, dependent on a temperature-sensing element (T2,T3,K) thermally coupled to the resonant circuit oscillator (1,2a,2b,T1), is controlled by a control device (S1,S2) in such a way that the switching distance of the proximity switch is temperature-stable, characterized in that the temperature sensing element has a first temperature sensor in the form of an element (T3,K) thermally coupled to the resonant circuit coil (1) which, as resistance rises with rising temperature of the resonant circuit coil (1), increases and reduces the current source (I3) via the control device (S1, S2), and a second temperature sensor (T2), thermally coupled to the resonant circuit transistor (T1) which, with the resonant circuit transistor (T1) operated in common-base circuit, adjusts the compensation current of the current source (I1) via the control device (S1) exclusively depending on the temperature of the resonant circuit transistor (T1) for the purpose of stabilizing the transconductance of the resonant circuit transistor (T1), and with the resonant circuit transistor operated in emitter circuit, adjusts the compensation current of. the current source (I2) via the control device (S1), depending on the set base current of the resonant circuit transistor in addition to the temperature of the resonant circuit transistor (T1), for the purpose of stabilizing the current reinforcing factor of the resonant circuit transistor (T1).

2. Proximity switch according to claim 1, characterized in that the temperature sensor coupled to the resonant circuit coil (1) is a transistor (T3).

3. Proximity switch according to claim 2, characterized in that the transistor (T3) is mounted directly on the resonant circuit coil (1).

4. Proximity switch according to claim 3, characterized in that, in the case of a resonant circuit coil (1) with a core, the transistor (T3) is mounted on the core.

5. Proximity switch according to claim 1, characterized in that, in the case of a resonant circuit coil (1) with a ferrite core (K), the temperature sensor is formed by the ferrite core (K) acting as ohmic resistance, with a resistance curve following an e-function for which the control device (2) has a linearization.

6. Proximity switch according to claim 5, characterized in that the control device (S2) is electrically connected directly via two measuring lines (F1,F2) to spaced-apart connection points (P1,P2) of the ferrite core (K).

7. Proximity switch according to any of claims 1 - 6, characterized in that the temperature sensor (T2) thermally coupled to the resonant circuit transistor is a transistor (T1).

8. Proximity switch according to claim 7, characterized in that the two transistors (T1,T2) thermally coupled to one another are formed on the same semiconductor crystal.

**Revendications**

1. Détecteur inductif de proximité, comprenant un oscillateur à circuit résonant transistorisé (1, 2a, 2b, T1) et une source de courant (I1, I2, I3) placée dans le circuit émetteur du transistor de circuit résonant (T1), source qui, en fonction d'un dispositif de mesure de température (T2, T3, K) couplé thermiquement à l'oscillateur de circuit résonant (1, 2a, 2b, T1), est commandée au moyen d'un dispositif de commande (S1, S2), de telle manière que la distance de déclenchement du détecteur de proximité est stable en température, caractérisé en ce que le dispositif de mesure de température présente un premier capteur de température sous la forme d'un élément (T3, K) couplé thermiquement à la bobine (1) du circuit résonant, élément qui augmente la source de courant (I3), par l'intermédiaire du dispositif de commande (S1, S2), lorsque la résistance augmente avec une température croissante de la bobine (1) du circuit résonant, et inversement, et un deuxième capteur de température (T2) couplé thermiquement au transistor (T1) du circuit résonant et qui, lorsque le transistor (T1) du circuit résonant fonctionne en montage à base commune, règle le courant de compensation de la source de courant (I1) par l'intermédiaire du dispositif de commande (S1) exclusivement en fonction de la température du transistor (T1) du circuit résonant au sens d'un maintien à valeur constante de la pente du transistor (T1) du circuit résonant, et qui, lorsque le transistor du circuit résonant fonctionne en montage à émetteur commun, règle le courant de compensation de la source de courant (I2) par l'intermédiaire du dispositif de commande (S1), en plus de la dépendance à la température du transistor (T1) du circuit résonant, également en fonction du courant de base du transistor du circuit résonant au sens d'un maintien à valeur constante du facteur d'amplification de courant du transistor (T1) du circuit résonant.

2. Détecteur de proximité selon la revendication 1, caractérisé en ce que le capteur de température couplé à la bobine (1) du circuit résonant est un transistor (T3).

3. Détecteur de proximité selon la revendication 2, caractérisé en ce que le transistor (T3) est monté directement sur la bobine (1) du circuit résonant.

4. Détecteur de proximité selon la revendication 3, caractérisé en ce que, la bobine (1) du circuit résonant présentant un noyau, le transistor (T3) est monté sur le noyau.

5. Détecteur de proximité selon la revendication 1, caractérisé en ce que, la bobine (1) du circuit résonant présentant un noyau en ferrite (K), le capteur de température est formé par le noyau en ferrite (K) agissant en résistance ohmique, pour la courbe caractéristique duquel, qui suit une fonction exponentielle, le dispositif de commande (S2) présente une linéarisation.

6. Détecteur de proximité selon la revendication 5, caractérisé en ce que le dispositif de commande (52) est raccordé électriquement par deux conducteurs de mesure (F1, F2) directement en des points de raccordement distants (P1, P2) du noyau en ferrite (K).

7. Détecteur de proximité selon l'une des revendications 1 à 6, caractérisé en ce que le capteur de température (T2) couplé thermiquement au transistor (T1) du circuit résonant est un transistor.

8. Détecteur de proximité selon la revendication 7, caractérisé en ce que les deux transistors (T1, T2) couplés thermiquement l'un à l'autre sont formés sur le même cristal semi-conducteur.

# Fig. 1

# Fig. 2

# Fig. 3

# Fig. 4

# Fig. 5

$$R = R_{25}\, e^{k\left(\frac{1}{T}-\frac{1}{T_{25}}\right)}$$

-25°C          25°C          75°C   $\vartheta_U$